# EUROPEAN PATENT APPLICATION

(11) **EP 4 757 535 A1**
(43) Date of publication of application: **10.06.2026**
(21) Application number: 25217879.3
(22) Date of filing: 24.11.2025
(51) Int. Cl.: H10D 89/60

(54) **DIODE STRUCTURE WITH ADJACENT BASE REGIONS**

(30) Priority: 06.12.2024 US 202418971228
(71) Applicant: INTEL Corporation, Santa Clara, CA 95054 (US)
(72) Inventor: DHAKAD, Harshit, 560066 Bangalore KA (IN); SHARMA, Anand, 560043 Bangalore (IN)
(74) Representative: 2SPL Patentanwälte PartG mbB

(57) **Abstract**

Techniques for protecting integrated circuits from electrostatic discharge (ESD). A diode structure includes multiple emitter, base, and collector connections across a substrate. The connections are made to either n-doped substrate regions (for collector and emitter in NPN diode) or p-doped regions (for the base in NPN diode). P-doped base regions are arranged adjacent to each other in the substrate and are separated by a dielectric wall (e.g., shallow trench isolation). N-doped emitter regions may be arranged between sets of p-doped base regions. This arrangement effectively enlarges the base area of the diode structure, which decreases the current density. Additionally, the adjacent base regions allow for a wider metal interconnect layer over the adjacent base regions and a greater spacing between adjacent base and emitter interconnect layers. PNP diode structure is similarly configured, but with the dopant scheme reversed (p-doped substrate regions for collector and emitter and n-doped regions for base).

## Description

### BACKGROUND

As integrated circuits continue to scale downward in size, a number of challenges arise. High-speed interfaces and radio frequency (RF) applications, operating at gigahertz frequencies, necessitate electrostatic discharge (ESD) protection solutions with minimal capacitance to avoid compromising signal integrity. As semiconductor processes advance into finer nanometer geometries, the design of diodes for ESD protection becomes increasingly complex. Particularly, in certain technology nodes, the maximum permissible dimensions for certain diode regions are constrained by the fabrication technology. Accordingly, there remain a number of non-trivial challenges with respect to providing innovative ESD solutions.

### BRIEF DESCRIPTION OF THE DRAWINGS

Figure 1 is a cross-sectional view that illustrates an example portion of an integrated circuit configured with an ESD region in the substrate having one or more diodes, in accordance with an embodiment of the present disclosure.
Figures 2A and 2B are cross-sectional views of different examples of ESD diode structures having a split anode configuration, in accordance with some embodiments of the present disclosure.
Figures 3A - 3H' are cross-sectional views that collectively illustrate an example process for forming an ESD diode with a split anode configuration, in accordance with an embodiment of the present disclosure.
Figures 4A and 4B are top-down views of an ESD diode structure having the split anode configuration, in accordance with some embodiments of the present disclosure.
Figure 5 illustrates a cross-section view of a chip package containing one or more semiconductor dies, in accordance with some embodiments of the present disclosure.
Figure 6 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles, and some features may have surface topology or otherwise be non-smooth, given real world limitations of the processing equipment and techniques used.

### DETAILED DESCRIPTION

Techniques are provided herein for protecting integrated circuits from electrostatic discharge (ESD) using a diode structure having a reduced current density in the base region and an overall reduced load capacitance and improved metallization. Although the techniques can be used in any number of integrated circuit applications, they are particularly useful with respect to circuits used in high-speed applications (e.g., operating at gigabit frequencies). In an example, an NPN diode structure includes multiple emitter, base, and collector connections across a substrate. The connections are made to either n-doped regions (for collector and emitter) or p-doped regions (for the base). According to some such embodiments, p-doped base regions are arranged adjacent to each other in the substrate and are separated by a dielectric wall (e.g., shallow trench isolation). N-doped emitter regions may be arranged between sets of p-doped base regions. This arrangement effectively enlarges the base area of the NPN diode structure, which decreases the current density. Additionally, the adjacent base regions allow for a wider metal interconnect layer over the adjacent base regions and a greater spacing between adjacent base and emitter interconnect layers. The same concepts can also readily be applied to a PNP diode structure, by reversing the dopant type in each region: p-doped regions (for collector and emitter) and n-doped regions (for the base). Numerous variations and embodiments will be apparent in light of this disclosure.

### General Overview

As previously noted above, there remain a number of non-trivial challenges with respect to mitigating ESD in semiconductor devices. Diodes are commonly included in circuits to help provide a conduction path to ground in response to an ESD event. Charge device model (CDM) ESD events are extremely fast with rise times in the range of 100ps and have high peak currents (e.g., several Amperes). Due to such fast rise times and high currents, overshoots are generated when ESD protection can't respond fast enough to the CDM pulse. Having a relatively high current density in the base (e.g., anode) compared to the emitter (e.g., cathode) acts to decrease the response time of the diode. Additionally, these diodes often introduce additional load capacitance that can degrade performance in high-speed environments. As semiconductor processes advance into finer nanometer scales, the design of NPN BJTs for ESD protection becomes increasingly complex. Particularly, in certain technology nodes, the maximum permissible dimensions for the P+ region (base) are constrained by the fabrication technology due to, for example, polysilicon (e.g., for enhanced ohmic contact) being placed on both sides of the P+ diffusion contact, which makes the P+ region (base) less than half the minimum size of the emitter (N+), posing significant ESD design challenges.

Thus, and in accordance with an embodiment of the present disclosure, techniques are provided herein to fabricate a diode structure having adjacent base regions to decrease the current density in the base regions, and allow for a metallization scheme that reduces both resistance and parasitic capacitance between adjacent interconnect layers. In an example, a semiconductor substrate (e.g., silicon substrate) includes any number of doped wells having either n-type or p-type dopants to form various base, emitter, and collector regions for a given diode structure. According to some embodiments, base regions (e.g., p-doped regions for NPN diodes, or n-doped regions for PNP diodes) are arranged adjacent to each other and separated by a dielectric wall. Dielectric walls may also be used to separate base regions from adjacent emitter regions (e.g., n-doped for NPN diodes, or p-doped regions for PNP diodes). The diode structure may include a repeating pattern of adjacent base regions alternating with emitter regions along with collector regions (e.g., same dopant type as emitter region) bookending either end of the pattern of base and emitter regions.

According to some embodiments, the spacing of the metal interconnect layers above the diode contacts may be optimized to reduce resistance and capacitance due to the arrangement of the adjacent base regions. For example, a first metal interconnect layer (e.g., first a conductive strip) having a first width may contact each of the contacts on a given emitter region while a second interconnect layer (a second conductive strip) having a second width may contact each of the contacts on the adjacent base regions. The second width is greater than the first width to reduce the resistance of the base interconnects, and the spacing between the first metal interconnect layer and the second metal interconnect layer may be increased to between about 200 nm and about 400 nm, such as around 260 nm, according to some embodiments. The increased spacing between the adjacent interconnect layers reduces the parasitic capacitance.

According to an embodiment, an integrated circuit includes a first doped well within a semiconductor substrate and being doped with a first dopant type, a second doped well nested within the first doped well and being doped with a second dopant type different from the first dopant type, a first doped region in the second doped well, a second doped region in the second doped well and adjacent to the first doped region along a first direction, a third doped region in the second doped well and adjacent to the second doped region along the first direction, and a dielectric wall separating the second doped region from the third doped region. The first doped region has the first dopant type, and the second and third doped regions each have the second dopant type.

According to another embodiment, an integrated circuit includes a semiconductor substrate doped with a first dopant type, a first doped region in the semiconductor substrate and having a second dopant type different from the first dopant type, a second doped region in the semiconductor substrate and adjacent to the first doped region along a first direction, a third doped region in the semiconductor substrate and adjacent to the second doped region along the first direction, and a dielectric wall separating the second doped region from the third doped region. Each of the second doped region and the third doped region has the first dopant type.

According to another embodiment, an electronic device includes a chip package having one or more dies. At least one of the one or more dies includes a doped well within a semiconductor substrate and being doped with a first dopant type, a first doped region in the doped well and having a second dopant type different from the first dopant type, a second doped region in the doped well and adjacent to the first doped region along a first direction, a third doped region in the doped well and adjacent to the second doped region along the first direction, and a dielectric wall separating the second doped region from the third doped region. Each of the second doped region and the third doped region has the first dopant type.

The techniques can be used with a substrate that includes any number of other semiconductor devices, such as any type of planar and non-planar transistors, including finFETs (sometimes called double-gate transistors, or tri-gate transistors), nanowire and nanoribbon transistors (sometimes called gate-all-around transistors), and thin film transistors, to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a remove metal gate, or RMG, process). Any number of semiconductor materials can be used in forming the transistors to which power is being supplied by a buried or backside power rail, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, such tools may indicate the presence of various doped regions in a substrate (e.g., one or more diode structures). In some embodiments (such as for NPN diode structures), the doped regions include adjacent p-doped regions (e.g., adjacent base regions) separated by a dielectric barrier. In some other example embodiments, such tools may indicate the presence of n-doped regions (e.g., emitter regions) on either ends of the adjacent p-doped regions. The metal interconnect layers above the doped regions may also include a wider metal interconnect layer over the p-doped regions compared to the metal interconnect layers over the n-doped regions. In some other embodiments (such as for PNP diode structures), the doped regions include adjacent n-doped regions (e.g., adjacent base regions) separated by a dielectric barrier. In some other example embodiments, such tools may indicate the presence of p-doped regions (e.g., emitter regions) on either ends of the adjacent n-doped regions. The metal interconnect layers above the doped regions may also include a wider metal interconnect layer over the n-doped regions compared to the metal interconnect layers over the p-doped regions. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer.

### Architecture

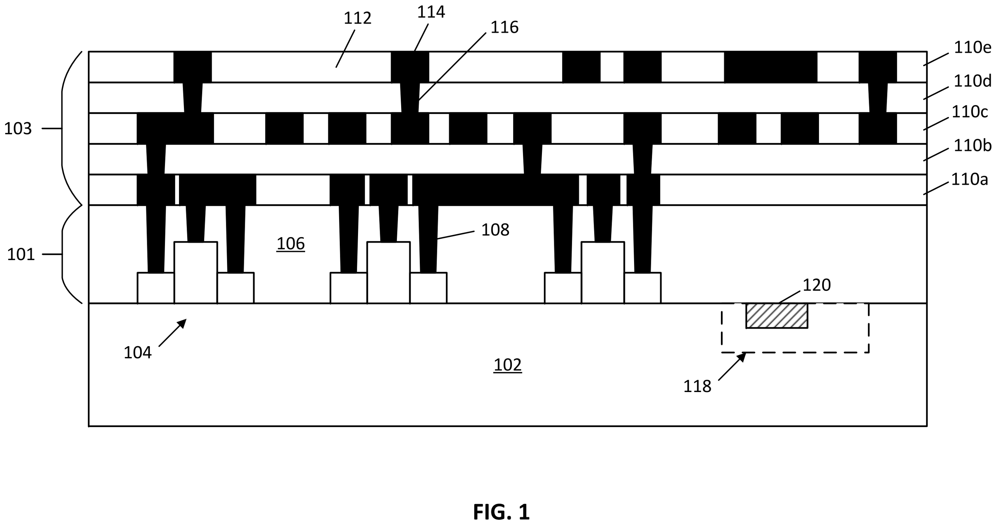

Figure 1 is a cross-sectional view that illustrates an example portion of an integrated circuit having an interconnect region above a plurality of semiconductor devices within a device layer, in accordance with an embodiment of the present disclosure. The semiconductor devices in this example are non-planar metal oxide semiconductor (MOS) transistors, such as tri-gate or gate-all-around (GAA) transistors, although other transistor topologies and types can also benefit from the techniques provided herein, as will be appreciated (e.g., planar transistors, forksheet transistors, thin film transistors, or any other transistors to which contact can be made). The device layer is over a substrate that includes a diode region having one or more NPN or PNP diodes.

According to some embodiments, the integrated circuit includes a device layer 101 (sometimes referred to as a device region), and an interconnect region 103 over the device layer 101. Device layer 101 may include a plurality of semiconductor devices 104 along with one or more other layers or structures associated with the semiconductor devices 104. For example, device layer 101 can also include one or more dielectric layers 106 that surround active portions or contacts of the semiconductor devices 104. Device layer 101 may also include one or more conductive contacts 108 that provide electrical contact to transistor elements such as gate structures, drain regions, or source regions. Conductive contacts 108 include, for example, tungsten, although other metal or metal alloy materials may be used as well. Conductive contacts may also be a part of, or otherwise include, what is sometimes called a local interconnect, which is considered part of the device layer and usually formed prior to any backend processing.

In some embodiments, device layer 101 is formed on or over a substrate 102. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, the substrate can be a semiconductor-on-insulator substrate having a desired semiconductor layer over a buried insulator layer (e.g., silicon over silicon dioxide). Alternatively, the substrate can be a multilayer substrate or superlattice suitable for forming nanowires or nanoribbons (e.g., alternating layers of silicon and SiGe, or alternating layers indium gallium arsenide and indium phosphide). Any number of substrates can be used. In some embodiments, backside processing is used to remove a lower portion of substrate 102 and form any number of backside interconnect layers.

Interconnect region 103 includes a plurality of interconnect layers 110a - 110e stacked over one another. Each interconnect layer can include a dielectric material 112 along with one or more different conductive features. Dielectric material 112 can be any dielectric, such as silicon oxide, silicon oxycarbide, silicon nitride, silicon oxynitride, tetraethyl orthosilicate (TEOS), or fluorinated tetraethyl orthosilicate (FTEOS). Dielectric material 112 may be deposited using any known dielectric deposition technique such as chemical vapor deposition (CVD), plasma-enhanced chemical vapor deposition (PECVD), flowable CVD, spin-on dielectric, or atomic layer deposition (ALD). The one or more conductive features can include conductive traces 114 and conductive vias 116 arranged in any pattern across the interconnect layers 110a - 110e to carry signal and/or power voltages to/from the various semiconductor devices 104. A conducive via, such as conductive via 116, may extend through an interconnect layer to connect between conductive traces on an upper interconnect layer and a lower interconnect layer. In other cases, a via 116 may only extend part way through a given interconnect layer. Although interconnect region 103 is illustrated with only five interconnect layers, any number of interconnect layers can be used within interconnect region 103. Also, this example shows vias and lines in different interconnect layers, in both single and dual damascene configurations. In other examples, vias and lines may also exist within the same interconnect layer, such as in the case of some dual damascene configurations.

Any of conductive traces 114 and conductive vias 116 can include any number of conductive materials, with some examples including copper, ruthenium, tungsten, cobalt, molybdenum, and alloys thereof. In some cases, any of conductive traces 114 and conductive vias 116 include a relatively thin liner or barrier, such as titanium nitride, titanium silicide, tungsten carbo-nitride (WCN), PVD or ALD tungsten, or tantalum nitride.

According to some embodiments, a diode region 118 within a portion of substrate 102 includes at least one NPN diode structure 120. As will be discussed in more detail herein, NPN diode structure 120 includes various doped regions that make up base, emitter, and collector portions of the NPN diode. Contacts may be made to the base, emitter, and collector portions of NPN diode structure 120 through device layer 101 to connect to one or more metal layers within interconnect region 103.

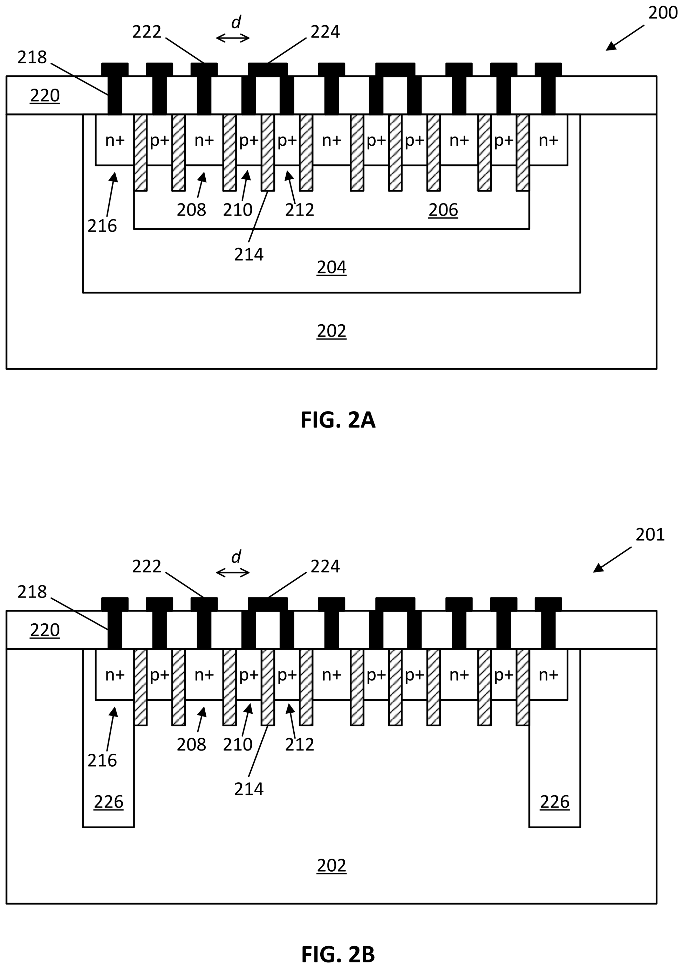

Figure 2A illustrates a cross-section through diode region 118 showing one example NPN diode structure 200, according to some embodiments. A semiconductor substrate 202 may be similar to substrate 102 described in above in Figure 1. NPN diode structure 200 includes a first doped well 204 and a second doped well 206 nested within first doped well 204. According to some embodiments, first doped well 204 includes a first dopant type and second doped well 206 includes a second dopant type that is the opposite from the first dopant type. In the example of an NPN diode, first doped well 204 includes n-type dopants and second doped well 206 includes p-type dopants. Examples of n-type dopants include phosphorous or arsenic, and examples of p-type dopants include boron. In some examples, substrate 202 is also doped with the same dopant type as second doped well 206 (e.g., p-type for an NPN diode). The dopant concentration may vary depending on the application. However, in some examples, first doped well 204 includes a dopant concentration of n-type dopants between about 10¹⁴ and 10¹⁵ and second doped well 206 includes a dopant concentration of p-type dopants between about 10¹⁴ and 10¹⁵. Any suitable doping technique may be used to form first doped well 204 and second doped well 206, including ion implantation or diffusion.

According to some embodiments, first doped regions 208 are formed within second doped well 206. First doped regions 208 may have the opposite dopant type compared to second doped well 206. Thus, in the example of an NPN diode, first doped regions 208 include n-type dopants, and may have an n-type dopant concentration between about 10¹⁹ and 10²¹. According to some embodiments, first doped regions 208 represent the emitter region of the NPN diode.

According to some embodiments, first doped regions 208 are separated along the first direction (e.g., a direction across the page) by an adjacent pair of doped regions that includes a second doped region 210 and a third doped region 212. Each of second doped region 210 and third doped region 212 includes the same dopant type of second doped well 206 (and the opposite dopant type of first doped regions 208). Thus, in the example of an NPN diode, second doped region 210 and third doped region 212 each include p-type dopants, and may have a p-type dopant concentration between about 10¹⁹ and 10²¹. Accordingly, second doped region 210 and third doped region 212 may include a higher p-type dopant concentration than second doped well 206. In some examples, second doped well 206 includes a relatively high p-type dopant concentration that is the same as second doped region 210 and third doped region 212. According to some embodiments, all doped regions are separated by a dielectric wall 214, including between doped regions of the same dopant type as is the case for dielectric wall 214 between second doped region 210 and third doped region 212. Dielectric wall 214 may be any suitable dielectric material, such as silicon dioxide, silicon nitride, silicon oxynitride, silicon oxycarbide, or other insulating materials. Dielectric wall 214 may extend into second doped well 206 to a depth that is at least greater than the depth of first doped regions 208. Dielectric wall 214 may have a width along the first direction between about 100 nm (or lower) and about 500 nm.

Second doped region 210 and third doped region 212 may represent the base region of the NPN diode. Using adjacent regions increases the area of the base region and lowers the current density at the base compared to the emitter regions.

According to some embodiments, fourth doped regions 216 are formed outside of second doped well 206 and within first doped well 204. Fourth doped regions 216 may include an n-type dopant concentration between about 10¹⁹ and 10²¹. Accordingly, fourth doped regions 216 may include a higher n-type dopant concentration than first doped well 204. In some examples, first doped well 204 includes a relatively high n-type dopant concentration that is the same as fourth doped regions 216. According to some embodiments, fourth doped regions 216 represent the collector region of the NPN diode.

According to some embodiments, any number of conductive contacts 218 are used to make electrical connection to the various doped regions of NPN diode structure 200. Conductive contacts 218 may extend through a dielectric layer 220 that includes any suitable dielectric material, such as silicon dioxide. Conductive contacts 218 may include any suitable conductive material, such as tungsten, ruthenium, molybdenum, or cobalt. According to some embodiments, any number of conductive contacts 218 may be used to make contact with each individual doped region. For example, each of first doped regions 208, second doped regions 210, third doped regions 212, and fourth doped regions 216 may extend into and out of the page along a second direction orthogonal to the first direction with any number of conductive contacts 218 spaced along the second direction to make contact with each doped region.

According to some embodiments, metal lines as part of an interconnect structure are coupled to contacts 218 to route the electrical signals to the corresponding base, collector, and emitter portions of NPN diode structure 200. First metal lines 222 may be formed over contacts 218 that connect to first doped regions 208 (e.g., emitter regions) and second metal lines 224 may be formed over contacts 218 that connect to both second doped region 210 and third doped region 212. According to some embodiments, second metal line 224 is wider than first metal line 222 along the first direction such that second metal line 224 couples to contacts 218 from both second doped region 210 and third doped region 212. In some examples, second metal line 224 is at least twice as wide compared to first metal line 222. In some examples, second metal line 224 is at least 2.5 times or 3 times as wide as first metal line 222. According to some embodiments, the spacing (d) between first metal line 222 and second metal line 224 may be increased due to the alignment of second metal line 224 between the contacts of second doped region 210 and third doped region 212. In some examples, the spacing d is between about 200 nm and about 400 nm, such as around 260 nm.

Figure 2B illustrates a cross-section through diode region 118 showing another example NPN diode structure 201, according to some embodiments. NPN diode structure 201 is similar to NPN diode structure 200 in its arrangement of base and emitter regions, however, it uses a different well doping scheme. According to some embodiments, NPN structure 201 includes one or more doped wells 226 that have an opposite dopant type compared to substrate 202. In the example of an NPN diode, doped wells 226 include n-type dopants and substrate 202 includes p-type dopants. In this example, first doped regions 208 are formed within substrate 202 and include the opposite dopant type from substrate 202. Second doped regions 210 and third doped regions 212 have the same dopant type as substrate 202, and have a greater dopant concentration as compared to substrate 202, according to some embodiments. The arrangement of contacts 218, first metal lines 222 and second metal lines 224 may be the same as described above for NPN diode structure 200.

As noted above, the improved NPN diode designs, such as NPN diode structure 200 or NPN diode structure 201, offer improved performance compared to conventional diodes that do not utilize adjacent base regions. Table 1 below provides a voltage response comparison between a conventional diode structure and the improved diode structure discussed herein.

**Table 1**

| **NPN diode type** | **Pulse Current (A)** | **Pulse Voltage (V)** | **Peak Voltage (V)** | **Overshoot Voltage (V)** |
|---|---|---|---|---|
| Conventional Diode | 2.18 | 4.3 | 7.26 | 2.96 |
| Improved Diode | 2.18 | 4.3 | 6.65 | 2.34 |
| Overshoot Improvement | | | | -0.62 |
| Overshoot % Difference | | | | -21% |

The peak voltage and overshoot voltage were measured after applying a very fast transmission line pulse (VFTLP) signal to the respective diode types. Each of the diodes has a same cathode area (e.g., area of the emitter regions) of around 10.8 square micrometers. The improved diode design (as described herein) demonstrates around a 21% decrease in overshoot compared to a conventional diode design without adjacent base regions. The reduction in overshoot is an important enhancement, as it suggests a lower risk of damage to the diode and to connected components during ESD events.

The improved diode designs also provide a lower parasitic capacitance compared to conventional diode designs as illustrated in Table 2 below.

**Table 2**

| **Cathode Areas of NPN Diodes** | **Total Diode Capacitance (F)** | | **% Cap Reduction** |
|---|---|---|---|
| | **Conventional Diode** | **Improved Diode** | |
| Area - 1.6 sq-µm | 1.22E-14 | 9.84E-15 | -19.6% |
| Area - 10.8 sq-µm | 9.32E-14 | 7.12E-14 | -23.6% |
| Area - 20.1 sq-µm | 1.72E-13 | 1.31E-13 | -23.9% |
| Area - 39.5 sq-µm | 3.43E-13 | 2.59E-13 | -24.4% |

As seen in Table 2, the improved diode design provides a reduced capacitance at all of the tested diode sizes. This reduction in capacitance is particularly advantageous for high-speed interfaces, as it minimizes the load capacitance added to the I/O link, thereby preserving signal integrity, and enabling faster data transmission rates without significant performance loss.

As discussed above, the wider metal lines above the adjacent base regions of the improved diode design reduce the diode resistance. A lower resistance in the diode's metallization enhances current flow and can lead to improved ESD protection efficiency. This reduction is beneficial for maintaining the performance of high-speed interfaces. The resistance reduction for diodes of various sizes is shown below in Table 3.

**Table 3**

| **Cathode Areas of NPN Diodes** | **Diode Metallization Resistance (Ohm)** | | **% Change in Resistance** |
|---|---|---|---|
| | **Conventional Diode** | **Improved Diode** | |
| Area - 1.6 sq-µm | 6.12 | 5.51 | -10.0% |
| Area - 10.8 sq-µm | 0.88 | 0.80 | -9.2% |
| Area - 20.1 sq-µm | 0.51 | 0.47 | -7.5% |
| Area - 39.5 sq-µm | 0.26 | 0.24 | -5.9% |

As further described above, the NPN diode structures shown in Figures 2A-B can be changed to PNP diode structures, by changing the n-doped regions to p-doped regions, and the p-doped regions to n-doped regions. The above relevant description equally applies here.

### Fabrication Methodology

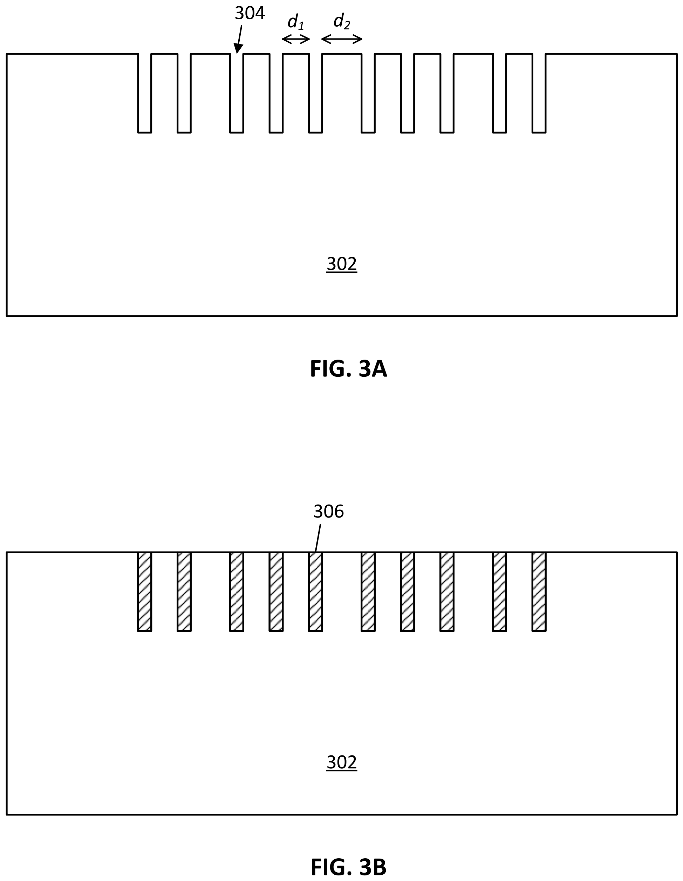

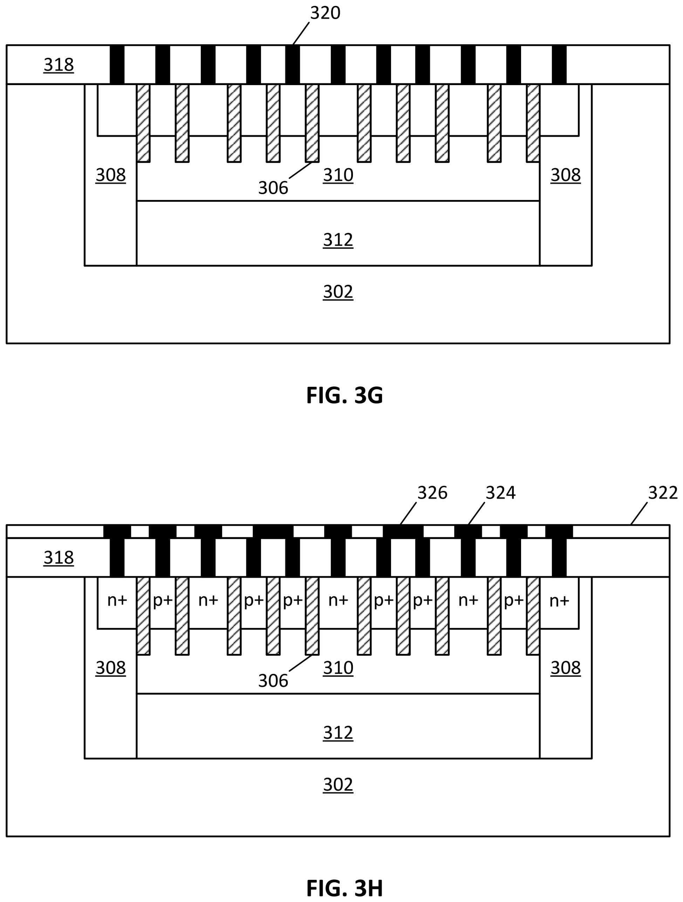

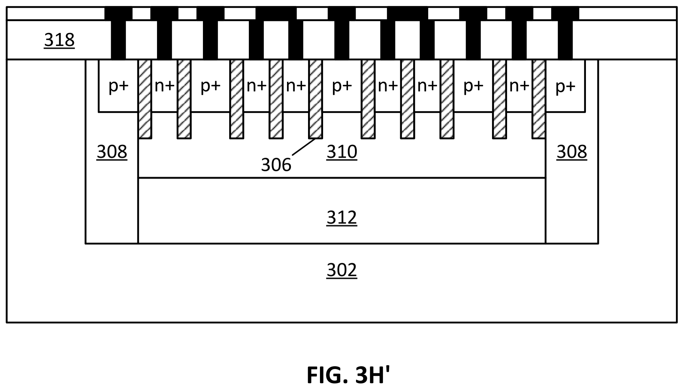

Figures 3A - 3H are cross-sectional views that collectively illustrate an example process for forming a portion of a diode region that includes a diode structure, in accordance with an embodiment of the present disclosure. Each figure shows an example structure that results from the process flow up to that point in time, so the depicted structure evolves as the process flow continues, culminating in the structure shown in Figure 3H. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 3A is a cross sectional view taken through a device substrate 302, according to some embodiments. Substrate 302 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 302 can be a semiconductor-on-insulator substrate having a desired semiconductor layer over a buried insulator layer (e.g., silicon over silicon dioxide). Alternatively, substrate 302 can be a multilayer substrate or superlattice suitable for forming nanowires or nanoribbons (e.g., alternating layers of silicon and SiGe, or alternating layers indium gallium arsenide and indium phosphide). Any number of substrates can be used.

According to some embodiments, trench-like recesses 304 are formed through a portion of substrate 302. Recesses 304 may have a width across a first direction (e.g., across the page) and extend into and out of the page along a second direction. Recesses 304 may be formed using any suitable semiconductor etching technique, such as reactive ion etching (RIE).

Recesses 304 separate the various portions of the diode (e.g., base, emitter, and collector portions). Thus, according to some embodiments, the arrangement of recesses 304 dictates the size and position of such diode regions. In the illustrated example, a group of three adjacent recesses 304 may be separated by a first distance d₁, while each repeating group of three recesses 304 is separated by a second, greater distance d₂. In some examples, distance d₂ is at least 50%, at least 75%, at least 100%, at least 125%, or at least 150% greater than distance d₁.

Figure 3B is the cross-sectional view of the structure depicted in Figure 3A after the formation of dielectric walls 306 within each of recesses 304, according to some embodiments. Dielectric walls 306 may include any suitable dielectric material, such as silicon dioxide, silicon nitride, silicon oxynitride, or silicon oxycarbide. The dielectric material may be formed using any suitable technique, such as chemical vapor deposition, atomic layer deposition, thermal oxidation, or spin-on dielectric. Following the formation of the dielectric material, excess dielectric material above recesses 304 may be removed using any suitable polishing procedure, such as for example, chemical mechanical polishing (CMP).

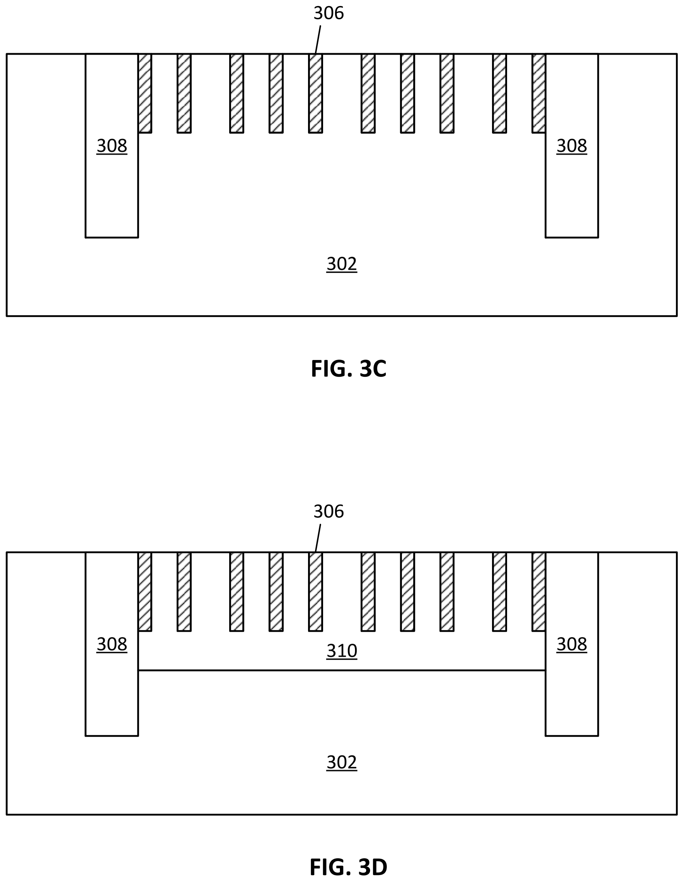

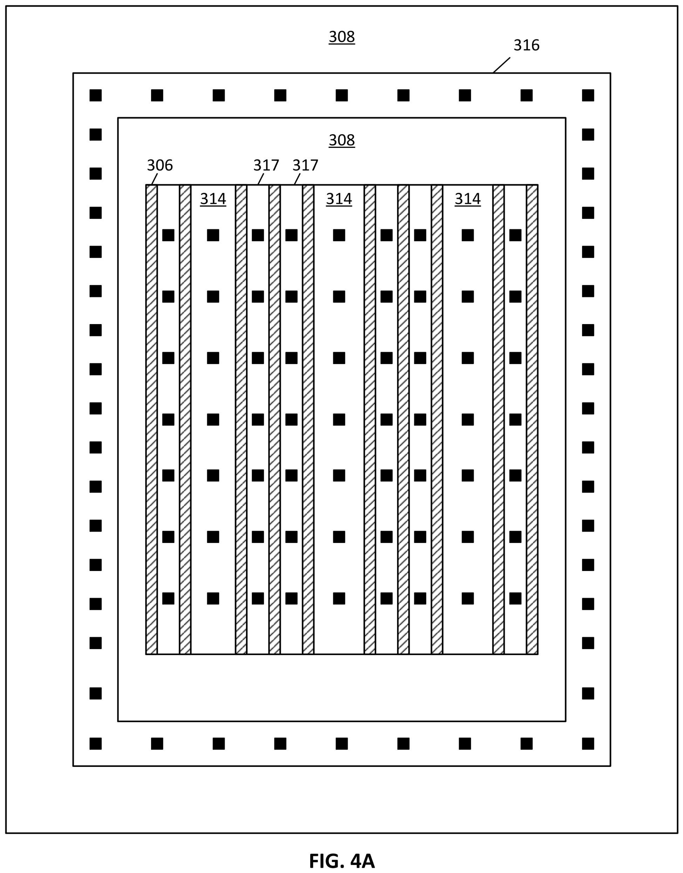

Figure 3C is the cross-sectional view of the structure depicted in Figure 3B after the formation of first well region 308, according to some embodiments. First well region 308 may be doped with a dopant type that is opposite from the dopant type of substrate 302. In the example of an NPN diode, first well region 308 may be doped with n-type dopants while substrate 302 is doped with p-type dopants. This doping scheme could be reversed for a PNP diode. First well region 308 may be formed using any suitable doping technique, such as ion implantation or diffusion. First well region 308 may have a concentration of n-type dopants between about 10¹⁴ and 10¹⁵. According to some embodiments, first well region 308 is formed in a perimeter around the group of dielectric walls 306 as seen more clearly in Figure 4A, which provides a top-down view of the NPN diode structure.

Figure 3D is the cross-sectional view of the structure depicted in Figure 3C after the formation of a doped well 310 within the perimeter of first well region 308, according to some embodiments. Doped well 310 may be doped with a dopant type that is opposite from the dopant type of first well region 308. In the example of an NPN diode, doped well 310 may be doped with p-type dopants. Doped well 310 may be formed using any suitable doping technique, such as ion implantation or diffusion. Doped well 310 may have a concentration of p-type dopants between about 10¹⁴ and 10¹⁵. In the example of a PNP diode, doped well 310 may be doped with n-type dopants, at a similar concentration (e.g., between about 10¹⁴ and 10¹⁵).

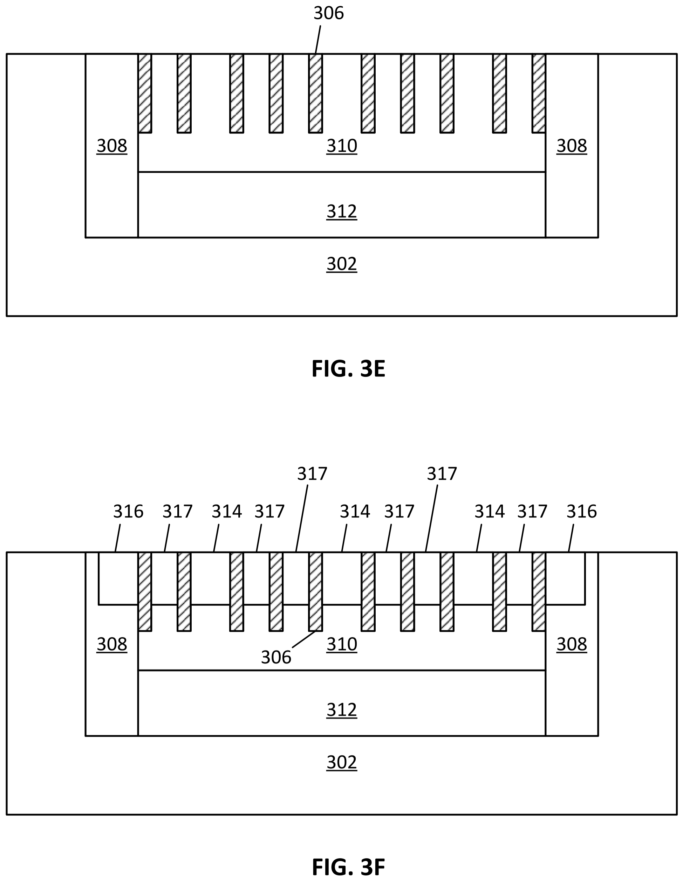

Figure 3E is the cross-sectional view of the structure depicted in Figure 3D after the formation of a second well region 312 beneath doped well 310, according to some embodiments. Second well region 312 may include the same dopant type as first well region 308 (e.g., n-type dopants) with substantially the same dopant concentration as first well region 308. An ion implantation process may be used to drive the dopants down below doped well 310. The combination of first well region 308 and second well region 312 may be considered a single doped well of n-type dopants in the case of an NPN diode. In the case of a PNP diode, first well region 308 and second well region 312 together would form a single doped well of p-type dopants.

Figure 3F is the cross-sectional view of the structure depicted in Figure 3E after the formation of various doped regions within doped well 310 and first well region 308, according to some embodiments. First doped regions 314 may be formed within portions of doped well 310 and second doped regions 316 may be formed in portions of first well region 308 outside of doped well 310. According to some such embodiments, first doped regions 314 have the opposite dopant type compared to doped well 310. In the example of an NPN diode, first doped regions 314 have a higher concentration of n-type dopants, such as an n-type doping concentration between about 10¹⁹ and 10²¹. According to some embodiments, second doped regions 316 similarly have the opposite dopant type compared to doped well 310. In the example of a PNP diode, first doped regions 314 have a higher concentration of p-type dopants. According to some such embodiments, second doped regions 316 similarly have the opposite dopant type compared to doped well 310.

According to some embodiments, dielectric walls 306 act as barriers between different doped regions across the diode structure. Thus, first doped regions 314 are flanked on either side by dielectric walls 306. According to some embodiments, at least two third doped regions 317 having the same dopant type as doped well 310 are adjacent to one another and bookended by first doped regions 314. According to some embodiments, third doped regions 317 have a higher p-type dopant concentration compared to doped well 310. For example, third doped regions 317 may have a p-type dopant concentration between about 10¹⁹ and 10²¹. According to some embodiments, each of first doped regions 314 are to be electrically coupled together to form the emitter terminal of the diode, each of the second doped regions 316 are to be electrically coupled together to form the collector terminal of the diode, and each of the third doped regions 317 are to be electrically coupled together to form the base terminal of the diode. In some embodiments, a polysilicon layer is formed over third doped regions 317 to enhance the ohmic contact with third doped regions 317 and also to serve as a barrier when doping first doped regions 314 and second doped regions 316.

Figure 3G is the cross-sectional view of the structure depicted in Figure 3F after the formation of a first dielectric layer 318 and contacts 320, according to some embodiments. First dielectric layer 318 may include any suitable dielectric material, such as silicon dioxide. In some examples, first dielectric layer 318 may be the first layer of a multilayer interconnect region. Contacts 320 may be any suitable metal or otherwise conductive material. As noted above, any number of contacts can be used to connect to a given doped region, including contacts arranged in a row that extends into and out of the page.

Figure 3H is the cross-sectional view of the structure depicted in Figure 3G after the formation of a second dielectric layer 322 and one or more metal lines extending through second dielectric layer 322, according to some embodiments. Second dielectric layer 322 may include any suitable dielectric material, and may be formed on top of first dielectric layer 318. According to some embodiments, first metal lines 324 may be formed on contacts 320 that connect to n-type regions (e.g., first doped regions 314 and second doped regions 316), and second metal lines 326 may be formed on contacts 320 that connect to adjacent p-type regions (e.g., third doped regions 317). This doping profile represents an NPN diode. The opposite doping profile representing a PNP diode is illustrated in Figure 3H' where first well region 308 and second well region 312 are doped with p-type dopants, and doped well 310 is doped wtih n-type dopants. Each of first and second metal lines 324/326 can include any suitable metal, such as any of tungsten, molybdenum, ruthenium, nickel or cobalt.

According to some embodiments, a given second metal line 326 is wider than any of first metal lines 324 and couples to contacts from more than one adjacent p-type region (e.g., more than one base region). For example, second metal lines 326 are at least 2 times, 2.5 times, or 3 times wider than first metal lines 324. Furthermore, as noted above, a distance between a given first metal line 324 and an adjacent second metal line 326 may be greater compared to conventional diode designs, such as between about 200 nm and about 400 nm, or around 260 nm.

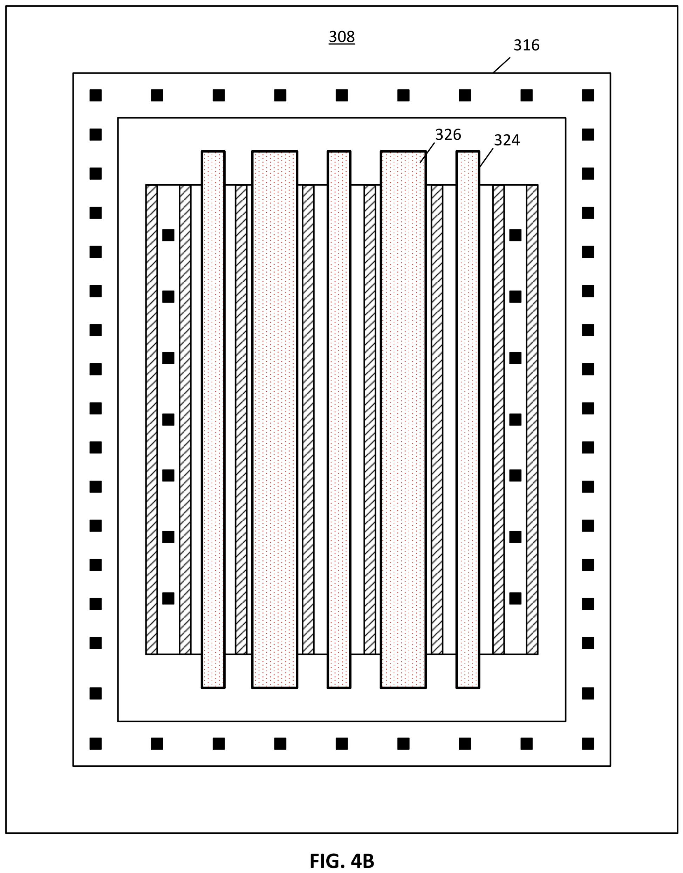

Figures 4A and 4B illustrate top-down views of an NPN diode structure similar to the one shown in the cross-section of Figure 3H, according to some embodiments. Figure 4A illustrates the NPN diode without the metal interconnect layers while Figure 4B includes the metal interconnect layers over the anode and cathode regions (and covering the contacts beneath them). First doped regions 314 (e.g., cathode) are shown adjacent to third doped regions 317 (e.g., anode), with two third doped regions 317 being directly adjacent to one another. Dielectric walls 306 separate each of the doped regions from one another across the page. According to some embodiments, first well region 308 surrounds the anode/cathode region (e.g., within doped well 310) of the NPN diode and second doped region 316 is shown in first well region 308. Second doped region 316 may be formed in a closed shape that encapsulates the anode/cathode region (e.g., within doped well 310). According to some embodiments, a plurality of contacts (illustrated as solid squares) are provided on each of first doped regions 314, second doped region 316, and third doped regions 317.

Figure 4B illustrates the metal lines 324/326 that connect to the underlying contacts on first doped regions 314 and third doped regions 317. As discussed above, second metal lines 326 may be wider compared to first metal lines 324 and may be formed on rows of contacts of two adjacent third doped regions 317. Furthermore, the distance between first metal lines 324 and adjacent second metal lines 326 may be increased due to the alignment of second metal lines 326 over two rows of contacts.

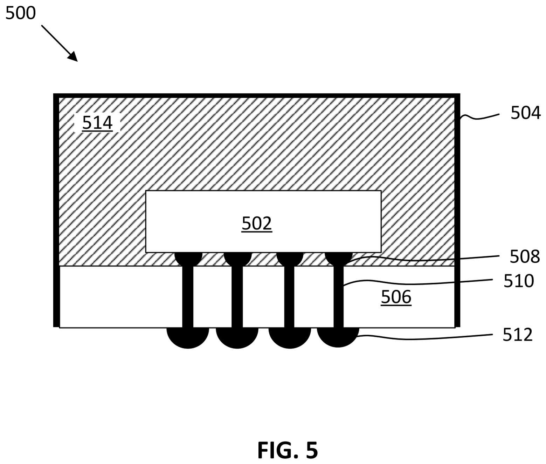

Figure 5 illustrates an example embodiment of a chip package 500, in accordance with an embodiment of the present disclosure. As can be seen, chip package 500 includes one or more dies 502. One or more dies 502 may include at least one integrated circuit having a structure as described in any of the aforementioned embodiments. One or more dies 502 may include any other circuitry used to interface with other devices formed on the dies, or other devices connected to chip package 500, in some example configurations.

As can be further seen, chip package 500 includes a housing 504 that is bonded to a package substrate 506. The housing 504 may be any standard or proprietary housing, and may provide, for example, electromagnetic shielding and environmental protection for the components of chip package 500. The one or more dies 502 may be conductively coupled to a package substrate 506 using connections 508, which may be implemented with any number of standard or proprietary connection mechanisms, such as solder bumps, ball grid array (BGA), pins, or wire bonds, to name a few examples. Package substrate 506 may be any standard or proprietary package substrate, but in some cases includes a dielectric material having conductive pathways (e.g., including conductive vias and lines) extending through the dielectric material between the faces of package substrate 506, or between different locations on each face. In some embodiments, package substrate 506 may have a thickness less than 1 millimeter (e.g., between 0.1 millimeters and 0.5 millimeters), although any number of package geometries can be used. Additional conductive contacts 512 may be disposed at an opposite face of package substrate 506 for conductively contacting, for instance, a printed circuit board (PCB). One or more vias 510 extend through a thickness of package substrate 506 to provide conductive pathways between one or more of connections 508 to one or more of contacts 512. Vias 510 are illustrated as single straight columns through package substrate 506 for ease of illustration, although other configurations can be used (e.g., damascene, dual damascene, through-silicon via, or an interconnect structure that meanders through the thickness of substrate 506 to contact one or more intermediate locations therein). In still other embodiments, vias 510 are fabricated by multiple smaller stacked vias, or are staggered at different locations across package substrate 506. In the illustrated embodiment, contacts 512 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 512, to inhibit shorting.

In some embodiments, a mold material 514 may be disposed around the one or more dies 502 included within housing 504 (e.g., between dies 502 and package substrate 506 as an underfill material, as well as between dies 502 and housing 504 as an overfill material). Although the dimensions and qualities of the mold material 514 can vary from one embodiment to the next, in some embodiments, a thickness of mold material 514 is less than 1 millimeter. Example materials that may be used for mold material 514 include epoxy mold materials, as suitable. In some cases, the mold material 514 is thermally conductive, in addition to being electrically insulating.

### Example System

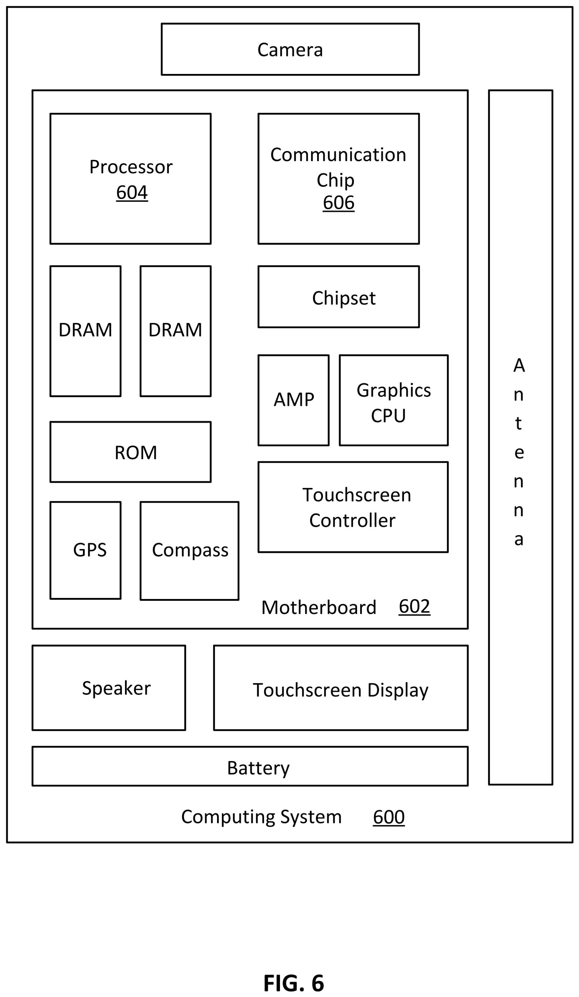

FIG. 6 is an example computing system implemented with one or more of the integrated circuit structures as disclosed herein, in accordance with some embodiments of the present disclosure. As can be seen, the computing system 600 houses a motherboard 602. The motherboard 602 may include a number of components, including, but not limited to, a processor 604 and at least one communication chip 606, each of which can be physically and electrically coupled to the motherboard 602, or otherwise integrated therein. As will be appreciated, the motherboard 602 may be, for example, any printed circuit board (PCB), whether a main board, a daughterboard mounted on a main board, or the only board of system 600, etc.

Depending on its applications, computing system 600 may include one or more other components that may or may not be physically and electrically coupled to the motherboard 602. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 600 may include one or more integrated circuit structures or devices configured in accordance with an example embodiment (e.g., a module including an integrated circuit having NPN or PNP diode structures, as variously provided herein). In some embodiments, multiple functions can be integrated into one or more chips (e.g., for instance, note that the communication chip 606 can be part of or otherwise integrated into the processor 604).

The communication chip 606 enables wireless communications for the transfer of data to and from the computing system 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing system 600 includes an integrated circuit die packaged within the processor 604. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 606 also may include an integrated circuit die packaged within the communication chip 606. In accordance with some such example embodiments, the integrated circuit die of the communication chip includes one or more semiconductor devices as variously described herein. As will be appreciated in light of this disclosure, note that multi-standard wireless capability may be integrated directly into the processor 604 (e.g., where functionality of any chips 606 is integrated into processor 604, rather than having separate communication chips). Further note that processor 604 may be a chip set having such wireless capability. In short, any number of processor 604 and/or communication chips 606 can be used. Likewise, any one chip or chip set can have multiple functions integrated therein.

In various implementations, the computing system 600 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 600 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first doped well within a semiconductor substrate and being doped with a first dopant type, a second doped well nested within the first doped well and being doped with a second dopant type different from the first dopant type, a first doped region in the second doped well, a second doped region in the second doped well and adjacent to the first doped region along a first direction, a third doped region in the second doped well and adjacent to the second doped region along the first direction, and a dielectric wall separating the second doped region from the third doped region. The first doped region has the first dopant type, and the second and third doped regions each have the second dopant type.

Example 2 includes the integrated circuit of Example 1, wherein the first dopant type comprises arsenic or phosphorous, and the second dopant type comprises boron.

Example 3 includes the integrated circuit of Example 1 or 2, wherein the second doped region and the third doped region each have a greater concentration of the second dopant type compared to the second doped well.

Example 4 includes the integrated circuit of any one of Examples 1-3, wherein the dielectric wall is a first dielectric wall and the integrated circuit further comprises a second dielectric wall separating the first doped region from the second doped region.

Example 5 includes the integrated circuit of any one of Examples 1-4, wherein the dielectric wall comprises silicon and oxygen.

Example 6 includes the integrated circuit of any one of Examples 1-5, wherein the dielectric wall has a width along the first direction between about 100 nm and about 500 nm.

Example 7 includes the integrated circuit of any one of Examples 1-6, further comprising a fourth doped region in the second doped well and adjacent to the third doped region along the first direction, the fourth doped region having the first dopant type.

Example 8 includes the integrated circuit of any one of Examples 1-7, further including one or more first conductive contacts on the first doped region, one or more second conductive contacts on the second doped region, and one or more third conductive contacts on the third doped region.

Example 9 includes the integrated circuit of Example 8, further including a first conductive strip conductively coupled to the one or more first conductive contacts and extending lengthwise in a second direction different from the first direction, and a second conductive strip conductively coupled to the one or more second conductive contacts and the one or more third conductive contacts, and extending lengthwise in the second direction.

Example 10 includes the integrated circuit of Example 9, wherein the second conductive strip is wider along the first direction compared to the first conductive strip.

Example 11 includes the integrated circuit of Example 9 or 10, wherein a distance between the first conductive strip and the second conductive strip along the first direction is between about 200 nm and about 400 nm.

Example 12 includes the integrated circuit of any one of Examples 9-11, wherein the second direction is orthogonal to the first direction.

Example 13 is a die that includes the integrated circuit of any one of Examples 1-12.

Example 14 is an integrated circuit that includes a semiconductor substrate doped with a first dopant type, a first doped region in the semiconductor substrate and having a second dopant type different from the first dopant type, a second doped region in the semiconductor substrate and adjacent to the first doped region along a first direction, a third doped region in the semiconductor substrate and adjacent to the second doped region along the first direction, and a dielectric wall separating the second doped region from the third doped region. Each of the second doped region and the third doped region has the first dopant type.

Example 15 includes the integrated circuit of Example 14, wherein the first dopant type comprises boron, and the second dopant type comprises arsenic or phosphorous.

Example 16 includes the integrated circuit of Example 14 or 15, wherein the second doped region and the third doped region each have a greater concentration of the first dopant type compared to the semiconductor substrate.

Example 17 includes the integrated circuit of any one of Examples 14-16, wherein the dielectric wall is a first dielectric wall and the integrated circuit further comprises a second dielectric wall separating the first doped region from the second doped region.

Example 18 includes the integrated circuit of any one of Examples 14-17, wherein the dielectric wall comprises silicon and oxygen.

Example 19 includes the integrated circuit of any one of Examples 14-18, wherein the dielectric wall has a width along the first direction between about 100 nm and about 500 nm.

Example 20 includes the integrated circuit of any one of Examples 14-19, further comprising a fourth doped region in the semiconductor substrate and adjacent to the third doped region along the first direction, the fourth doped region having the second dopant type.

Example 21 includes the integrated circuit of any one of Examples 14-20, further including one or more first conductive contacts on the first doped region, one or more second conductive contacts on the second doped region, and one or more third conductive contacts on the third doped region.

Example 22 includes the integrated circuit of Example 21, further including a first conductive strip conductively coupled to the one or more first conductive contacts and extending lengthwise in a second direction different from the first direction, and a second conductive strip conductively coupled to the one or more second conductive contacts and the one or more third conductive contacts, and extending lengthwise in the second direction.

Example 23 includes the integrated circuit of Example 22, wherein the second conductive strip is wider along the first direction compared to the first conductive strip.

Example 24 includes the integrated circuit of Example 22 or 23, wherein a distance between the first conductive strip and the second conductive strip along the first direction is between about 200 nm and about 400 nm.

Example 25 includes the integrated circuit of any one of Examples 22-24, wherein the second direction is orthogonal to the first direction.

Example 26 is a die that includes the integrated circuit of any one of Examples 14-25.

Example 27 is an electronic device including a chip package having one or more dies. At least one of the one or more dies includes a doped well within a semiconductor substrate and being doped with a first dopant type, a first doped region in the doped well and having a second dopant type different from the first dopant type, a second doped region in the doped well and adjacent to the first doped region along a first direction, a third doped region in the doped well and adjacent to the second doped region along the first direction, and a dielectric wall separating the second doped region from the third doped region. Each of the second doped region and the third doped region has the first dopant type.

Example 28 includes the electronic device of Example 27, wherein the first dopant type comprises boron, and the second dopant type comprises arsenic or phosphorous.

Example 29 includes the electronic device of Example 27 or 28, wherein the second doped region and the third doped region each have a greater concentration of the first dopant type compared to the doped well.

Example 30 includes the electronic device of any one of Examples 27-29, wherein the dielectric wall is a first dielectric wall and the at least one of the one or more dies further includes a second dielectric wall separating the first doped region from the second doped region.

Example 31 includes the electronic device of any one of Examples 27-30, wherein the dielectric wall comprises silicon and oxygen.

Example 32 includes the electronic device of any one of Examples 27-31, wherein the dielectric wall has a width along the first direction between about 100 nm and about 500 nm.

Example 33 includes the electronic device of any one of Examples 27-32, wherein the at least one of the one or more dies further comprises a fourth doped region in the doped well and adjacent to the third doped region along the first direction, the fourth doped region having the second dopant type.

Example 34 includes the electronic device of any one of Examples 27-33, wherein the at least one of the one or more dies further includes one or more first conductive contacts on the first doped region, one or more second conductive contacts on the second doped region, and one or more third conductive contacts on the third doped region.

Example 35 includes the electronic device of Example 34, wherein the at least one of the one or more dies further includes a first conductive strip conductively coupled to the one or more first conductive contacts and extending lengthwise in a second direction different from the first direction, and a second conductive strip conductively coupled to the one or more second conductive contacts and the one or more third conductive contacts, and extending lengthwise in the second direction.

Example 36 includes the electronic device of Example 35, wherein the second conductive strip is wider along the first direction compared to the first conductive strip.

Example 37 includes the electronic device of Example 35 or 36, wherein a distance between the first conductive strip and the second conductive strip along the first direction is between about 200 nm and about 400 nm.

Example 38 includes the electronic device of any one of Examples 35-37, wherein the second direction is orthogonal to the first direction.

Example 39 includes the electronic device of any one of Examples 27-38, further comprising a printed circuit board, wherein the chip package is coupled to the printed circuit board.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first doped well within a semiconductor substrate, the first doped well being doped with a first dopant type;
a second doped well nested within the first doped well, the second doped well being doped with a second dopant type different from the first dopant type;
a first doped region in the second doped well, the first doped region having the first dopant type;
a second doped region in the second doped well and adjacent to the first doped region along a first direction, the second doped region having the second dopant type;
a third doped region in the second doped well and adjacent to the second doped region along the first direction, the third doped region having the second dopant type; and
a dielectric wall separating the second doped region from the third doped region.

2. The integrated circuit of claim 1, wherein the first dopant type comprises arsenic or phosphorous, and the second dopant type comprises boron.

3. The integrated circuit of claim 1 or 2, wherein the second doped region and the third doped region each have a greater concentration of the second dopant type compared to the second doped well.

4. The integrated circuit of any one of claims 1 through 3, wherein the dielectric wall is a first dielectric wall and the integrated circuit further comprises a second dielectric wall separating the first doped region from the second doped region.

5. The integrated circuit of any one of claims 1 through 4, wherein the dielectric wall comprises silicon and oxygen.

6. The integrated circuit of any one of claims 1 through 5, wherein the dielectric wall has a width along the first direction between about 100 nm and about 500 nm.

7. The integrated circuit of any one of claims 1 through 6, further comprising a fourth doped region in the second doped well and adjacent to the third doped region along the first direction, the fourth doped region having the first dopant type.

8. The integrated circuit of any one of claims 1 through 7, further comprising:
one or more first conductive contacts on the first doped region;
one or more second conductive contacts on the second doped region; and
one or more third conductive contacts on the third doped region.

9. The integrated circuit of claim 8, further comprising:
a first conductive strip conductively coupled to the one or more first conductive contacts and extending lengthwise in a second direction different from the first direction; and
a second conductive strip conductively coupled to the one or more second conductive contacts and the one or more third conductive contacts, and extending lengthwise in the second direction.

10. The integrated circuit of claim 9, wherein the second conductive strip is wider along the first direction compared to the first conductive strip.

11. The integrated circuit of claim 9 or 10, wherein a distance between the first conductive strip and the second conductive strip along the first direction is between about 200 nm and about 400 nm.

12. The integrated circuit of any one of claims 9 through 11, wherein the second direction is orthogonal to the first direction.

13. A die comprising the integrated circuit of any one of claims 1 through 12.
